# EUROPEAN PATENT APPLICATION

(11) **EP 4 137 834 A1**
(43) Date of publication of application: **22.02.2023**
(21) Application number: 21191724.0
(22) Date of filing: 17.08.2021
(51) Int. Cl.: G01R 33/483, G01R 33/54, G01R 33/56, G01R 33/561, G01R 33/44, G01R 33/50, G01R 33/563

(54) **MULTI-REGION MR FINGERPRINTING**

(71) Applicant: Koninklijke Philips N.V., 5656 AG Eindhoven (NL)
(72) Inventor: BOERNERT, Peter, 5656 AE Eindhoven (NL); NEHRKE, Kay, 5656 AE Eindhoven (NL); AMTHOR, Thomas Erik, 5656 AE Eindhoven (NL); MEINEKE, Jan Jakob, 5656 AE Eindhoven (NL); BAUMANN, Manuel, 5656 AE Eindhoven (NL); MAZURKEWITZ, Peter Caesar, 5656 AE Eindhoven (NL); KEUPP, Jochen, 5656 AE Eindhoven (NL); DONEVA, Mariya Ivanova, 5656 AE Eindhoven (NL); VAN DEN BRINK, Johan Samuel, 5656 AE Eindhoven (NL)
(74) Representative: Philips Intellectual Property & Standards

(57) **Abstract**

The invention relates to a method of MR imaging of an object (10) placed in an examination volume of an MR system (1). It is an object of the invention to provide an improved quantitative MR imaging technique. The method comprises the steps of: subjecting the object (10) to an imaging sequence which generates MR signals in two or more spatially separate slices or volumes, wherein the imaging sequence is composed of a train of sequence blocks, each sequence block comprising at least one RF pulse and at least one switched readout magnetic field gradient defining a k-space sampling pattern and having associated therewith a set of acquisition parameters, acquiring the MR signals, wherein the MR signals are generated and/or manipulated in only a subset of said slices or volumes during each sequence block to acquire the MR signals in a time-multiplexed manner from all of the slices or volumes while simultaneously varying at least one acquisition parameter during the course of the imaging sequence, and reconstructing at least one MR image for each slice or volume, wherein one or more MR parameters are computed for a number of image positions from the temporal evolution of the acquired MR signals caused by the variation of the at least one acquisition parameter. Moreover, the invention relates to an MR system (1) for carrying out this method as well as to a computer program to be run on an MR system.

## Description

### FIELD OF THE INVENTION

The invention relates to the field of magnetic resonance (MR) imaging. It concerns a method of MR imaging of an object. The invention also relates to an MR system and to a computer program to be run on an MR system.

### BACKGROUND OF THE INVENTION

Image-forming MR methods which utilize the interaction between magnetic fields and nuclear spins in order to form two-dimensional or three-dimensional images are widely used nowadays, notably in the field of medical diagnostics, because for imaging of soft tissue they are superior to other imaging methods in many respects, do not require ionizing radiation and are usually not invasive.

MR fingerprinting (MRF) uses the generation of a temporally and spatially incoherent MR signal evolution (forming a "fingerprint") for different material (tissue) types through continuous variation of the acquisition parameters, such as the flip angle, the radiofrequency (RF) phase, the repetition time (TR), and the k-space sampling pattern, during the course of the used imaging sequence (see: Nature 495:187-192, 2013). To this end, the imaging sequence is composed of a train of sequence blocks, of which each comprises at least one RF pulse and at least one switched readout magnetic field gradient defining a k-space sampling pattern. An individual set of acquisition parameters is associated with each sequence block. A pattern matching algorithm matches the fingerprints to a predefined dictionary of predicted MR signal evolution patterns. The so obtained MR parameter maps, such as T₁, T₂, frequency shift and proton density maps, others are conceivable as well, are estimated from the best signal matching. Because of the incoherent sampling and the nature of the matching procedure based on prior knowledge, MRF has been shown to be comparatively insensitive with regard to errors even in combination with a highly undersampled k-space acquisition causing severe aliasing artifacts.

To enable an accurate estimation of the MR parameters using MRF a train of one thousand or more sequence blocks, each forming a time point of the temporal evolution of the acquired MR signals, is required. This results in an acquisition time of 10-30 s per slice. To create high-resolution volumetric MR parameter maps typically, hundred or more slices are required resulting in total acquisition times that can exceed easily half an hour.

In the so-called MR STAT technique (Magnetic Resonance Spin TomogrAphy in Time-domain, see: Magnetic Resonance Imaging 46:56-62, 2018) the ensemble of magnetic spins in the examined object is treated as a large-scale nonlinear dynamical system, which is probed by superimposing a train of imaging sequence blocks with incoherently varying acquisition parameters (as in MRF). Quantitative MR imaging is performed on this basis as a one step process; signal localization and parameter quantification are simultaneously obtained by the solution of a large scale nonlinear inversion problem. Quantitative parameter maps are reconstructed by employing nonlinear optimization algorithms and parallel computing infrastructures which do not rely on Fourier transformation. The advantage of MR STAT is that the constraints on the measurement process can be relaxed and acquisition schemes that are time efficient and widely available in clinical MR imaging scanners can be employed. The downside is that the reconstruction procedure (involving solving an inversion problem with typically about 10⁵ unknowns) is computationally very complex and demanding.

The concepts of MRF and MR STAT have scientifically been tested, but for broad clinical adoption, there is a need to accelerate the acquisition process.

It has been proposed (see: Magnetic Resonance in Medicine 75:2078-2085, 2016) to use a simultaneous multi-slice (SMS) imaging technique to accelerate MRF acquisition (SMS-MRF). The SMS technique applies multi-band composite RF pulses with a slice-selective magnetic field gradient to simultaneously excite multiple slice planes. SMS is used in combination with a modified Controlled Aliasing In Parallel Imaging Results In Higher Acceleration (CAIPIRINHA) approach for MRF to provide controlled aliasing differences between the simultaneously excited slices. This controlled aliasing, along with an appropriate parallel imaging reconstruction, is used to disentangle the MR signal trains for the individual slices allowing to convert the acquired superimposed MR signals into quantitative MR parameter maps for each of the simultaneously acquired slices.

### SUMMARY OF THE INVENTION

It is an object of the invention to provide an improved quantitative MR imaging technique.

In accordance with the invention, a method of MR imaging of an object placed in an examination volume of an MR system is disclosed. The method comprises the steps of:
- subjecting the object to an imaging sequence which generates MR signals in two or more spatially separate slices or volumes, wherein the imaging sequence is composed of a train of sequence blocks, each sequence block comprising at least one RF pulse and at least one switched readout magnetic field gradient defining a k-space sampling pattern and having associated therewith a set of acquisition parameters,
- acquiring the MR signals, wherein the MR signals are generated and/or manipulated in only a subset of said slices or volumes during each sequence block to acquire the MR signals in a time-multiplexed manner from all of the slices or volumes while simultaneously varying at least one acquisition parameter during the course of the imaging sequence, and
- reconstructing at least one MR image for each slice or volume, wherein one or more MR parameters are computed for a number of image positions from the temporal evolution of the acquired MR signals caused by the variation of the at least one acquisition parameter.

The technique of the invention generally corresponds to the above-mentioned SMS-MRF technique. MR signals are generated in two or more spatially separate slices or volumes, wherein the train of sequence blocks with varying acquisition parameters generates a characteristic MR signal evolution (fingerprint) from which the MR parameters are quantitatively derived for each image position. The essential feature of the invention is that MR signals are generated in and acquired from only a subset of the slices or volumes at a time (i.e., during each sequence block). Different subsets are addressed by different sequence blocks so that all slices or volumes are completely sampled during the course of the imaging sequence. This results in a quasi-simultaneous sampling of the multiple slices or volumes with multiplexing between these in the time domain enabling a significant increase of scanning efficiency compared to conventional MRF.

The approach of the invention further allows to define an individual, optimized variation of the acquisition parameters for each slice or volume such that the temporal evolution of the MR signals generated by the variation of the acquisition parameters is correspondingly different in each slice or volume to maximize the discrimination between different MR parameters for the respective slice or volume.

In an embodiment of the invention, the RF pulses of at least some of the sequence blocks are single-band RF pulses to generate MR signals in only a single slice or volume. This enables the generation and/or manipulation of MR signals in only a single image slice or volume at a time. This facilitates the assignment of the recorded MR signals to the individual slices or volumes during reconstruction.

In another embodiment, the RF pulses of at least some of the sequence blocks are multi-band RF pulses generating MR signals in all or a number of slices or volumes of the subset. In this embodiment, the MR signals can be generated in two or more slices or volumes simultaneously during each sequence block or at least during some of the sequence blocks. This variant helps to further increase scan efficiency as MR signals are not necessarily acquired from only a single slice or volume at a time.

The multi-band RF pulses may be designed to impart a modulation onto the MR signals generated in the slices or volumes of the subset. E.g., the multi-band RF pulses can be designed to provide the generation of MR signals in the slices or volumes of the subset with different flip angles. This can be employed to generate different temporal evolutions of the acquired MR signals for optimum discrimination between different MR or tissue parameters in each different slice or volume.

In a possible embodiment, the acquisition parameters varied during the course of the imaging sequence are one or more of: repetition time, echo time, flip angle, RF pulse phase and/or frequency, k-space sampling pattern, readout magnetic field gradient and/or longitudinal magnetization preparation. Like in the conventional MRF technique an MR signal acquisition scheme is applied that causes MR signals from different materials to be spatially and temporally incoherent by continuously varying the acquisition parameters throughout the data acquisition process. The mentioned acquisition parameters can be used for this purpose. The acquisition parameters can be varied in a random manner, pseudorandom manner, or other manner that results in MR signals from different materials to be spatially incoherent, temporally incoherent, or both.

As mentioned before, the variation of the acquisition parameters achieves spatial incoherence, temporal incoherence, or both, by varying the acquisition parameters from one sequence block to the next. This creates a time series of MR images with varying contrast. The MRF reconstruction process is designed to map any of a wide variety of MR parameters, such as longitudinal relaxation time T₁, transverse relaxation time T₂, main or static magnetic field Bo, diffusion coefficient, spin (proton) density for each of the slices or volumes. To achieve this, the slice or volume-specific temporal evolution of the acquired MR signal data is compared with a dictionary of MR signal evolution patterns, that have been generated in advance for different acquisition parameters based on MR signal models, such as Bloch equation-based physics simulations. This comparison allows for the estimation of the MR parameters. In general, the MR parameters at a given image position are estimated to be the parameters that provide the best match between the acquired MR signal evolution and the predicted MR signal evolution pattern. A conventional pattern matching algorithm may be used for this purpose.

The method of the invention described thus far can be carried out by means of an MR system comprising at least one main magnet coil for generating a main magnetic field within an examination volume, a number of gradient coils for generating switched magnetic field gradients in different spatial directions within the examination volume, at least one RF coil for generating RF pulses within the examination volume and/or for receiving MR signals from an object positioned in the examination volume, a control computer for controlling a temporal succession of RF pulses and switched magnetic field gradients based on an examination protocol, and a reconstruction unit for reconstructing MR images from the received MR signals.

The method of the invention can be implemented, for example, by a corresponding programming of the reconstruction unit and/or the control unit of the MR system.

The method of the invention can be advantageously carried out in most MR systems in clinical use at present. To this end it is merely necessary to utilize a computer program by which the MR system is controlled such that it performs the above-explained method steps of the invention. The computer program may be present either on a data carrier or be present in a data network so as to be downloaded for installation in the control unit of the MR system.

### BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:
Fig. 1 shows an MR system for carrying out the method of the invention;
Fig. 2 schematically illustrates a train of sequence blocks for MR signal acquisition from three slices or volumes using single-band RF pulses according to embodiments of the invention;
Fig. 3 schematically illustrates a train of sequence blocks for MR signal acquisition from three slices or volumes using single-band and multi-band RF pulses according to embodiments of the invention;
Fig. 4 schematically illustrates a train of sequence blocks for MR signal acquisition from three slices or volumes using only multi-band RF pulses according to embodiments of the invention;
Fig. 5 schematically illustrates a train of sequence blocks for MR signal acquisition from three slices or volumes employing magnetization preparation.

### DETAILED DESCRIPTION OF THE EMBODIMENTS

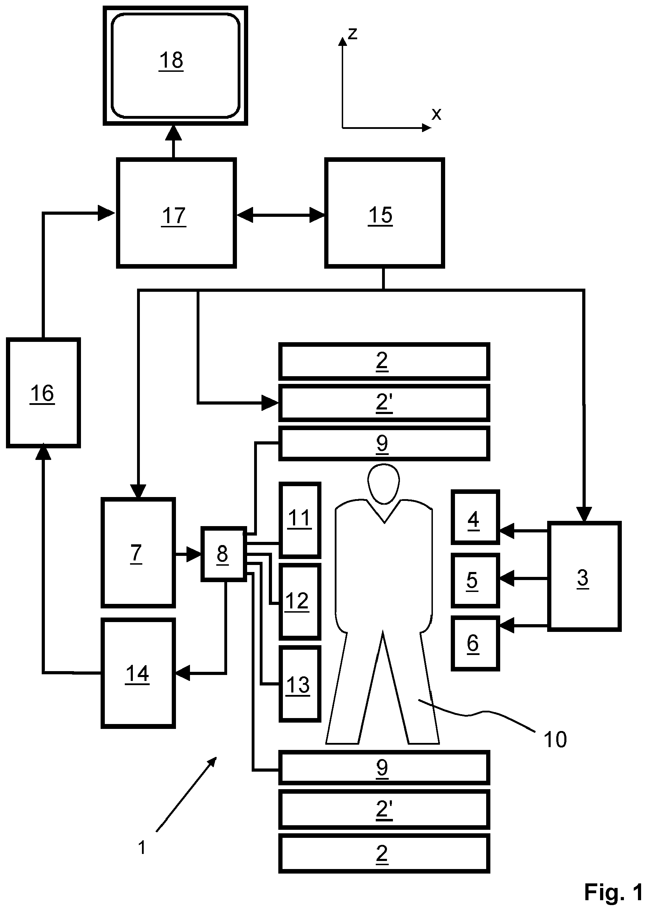

With reference to Fig. 1, an MR system 1 is shown. The system comprises superconducting or resistive main magnet coils 2 such that a substantially uniform, temporally constant main magnetic field is created along a z-axis through an examination volume.

A magnetic resonance generation and manipulation system applies a series of RF pulses and switched magnetic field gradients to invert or excite nuclear magnetic spins, induce magnetic resonance, refocus magnetic resonance, manipulate magnetic resonance, spatially and otherwise encode the magnetic resonance, saturate spins, and the like to perform MR imaging.

More specifically, a gradient pulse amplifier 3 applies current pulses to selected ones of whole-body gradient coils 4, 5 and 6 along x, y and z-axes of the examination volume. A digital RF frequency transmitter 7 transmits RF pulses or pulse packets, via a send-/receive switch 8, to a whole-body volume RF coil 9 to transmit RF pulses into the examination volume. A typical MR imaging sequence is composed of a packet of RF pulse segments of short duration which taken together with each other and any applied magnetic field gradients achieve a selected manipulation of nuclear magnetic resonance. The RF pulses are used to saturate, excite resonance, invert magnetization, refocus resonance, or manipulate resonance and select a portion of an object (a body of a patient) 10 positioned in the examination volume.

For generation of MR images of limited regions of the body 10 by means of parallel imaging, a set of local RF coils 11, 12, 13 are placed contiguous to the region selected for imaging. The resultant MR signals are picked up by the RF coils 11, 12, 13 and demodulated by a receiver 14 preferably including a preamplifier (not shown). The receiver 14 is connected to the RF coils 9, 11, 12 and 13 via send-/receive switch 8.

A host computer 15 controls the gradient pulse amplifier 3 and the transmitter 7 to generate any of a plurality of MR imaging sequences, such as echo planar imaging (EPI), echo volume imaging, gradient and spin echo imaging, fast spin echo imaging, and the like. For the selected sequence, the receiver 14 receives a single or a plurality of MR data lines in rapid succession following each RF excitation pulse. A data acquisition system 16 performs analog-to-digital conversion of the received signals and converts each MR data line to a digital format suitable for further processing. In modern MR systems the data acquisition system 16 is a separate computer, possibly a remote server "in the cloud", which is specialized in acquisition of raw image data.

Ultimately, the digital raw image data is reconstructed into an image representation by a reconstruction processor 17 which applies a Fourier transform or other appropriate reconstruction algorithms. The MR image may represent a planar slice through the patient, an array of parallel planar slices, a three-dimensional volume, or the like. The image is then stored in an image memory where it may be accessed for converting slices, projections, or other portions of the image representation into appropriate format for visualization, for example via a video monitor 18 which provides a man-readable display of the resultant MR image.

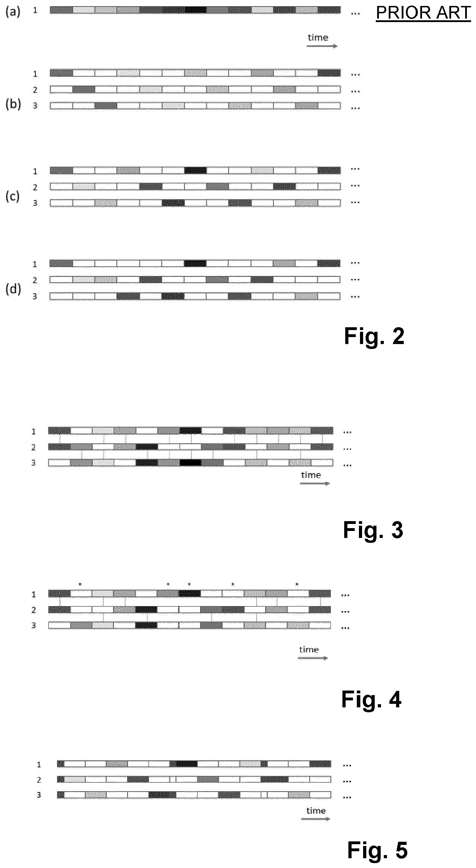

With continuing reference to Fig. 1 and with further reference to Figs. 2-6 embodiments of the imaging approach of the invention are explained.

Fig. 2a illustrates the classical MRF imaging sequence. Each small rectangle in the train, given as a function of time, denotes one basic gradient-echo sequence block which is equipped with an appropriate k-space sampling pattern (spiral, EPI, radial, Cartesian). Such blocks are repeated (after potential spin inversion in the beginning, not shown) in time with varying acquisition parameters (flip angle, TE, TR, ...). The different acquisition parameters applied in each sequence block are indicated by the different gray levels (for simplicity, the duration TR is assumed to be fixed for all blocks).

In Fig. 2b, three slices or volumes are addressed by the MRF imaging sequence quasi-simultaneously. MR signal generation and/or manipulation takes only place in one slice or volume at a given time. White blocks in the train indicate a zero flip angle in this context such that no (fresh) MR signal is generated in the respective slice or volume. In the embodiment of Fig. 2b, the MR signal generation and acquisition cycles through the different slices or volumes. In Figs. 2c and 2d more sophisticated, possibly stochastic sampling schemes are applied involving also other MRF temporal evolution functions over time in the different slices / volumes.

As it is shown in Fig. 2, instead of sampling one traditional MRF train (Fig. 2a), multiple trains are sampled according to the invention quasi simultaneously from different slices or volumes. However, this does not necessarily mean that an MRF train, once defined for a single slice or volume, is now applied in a time-multiplexed manner to several trains running in parallel for more than one slice or volume, as it is shown in Fig. 2b. In the scheme of Fig. 2b, the same dictionary of predicted MR signal evolution patterns for matching the temporal evolution of the acquired MR signals can be used for all individual slices / volumes to derive the MR parameters. In some special cases, e.g. when global magnetization preparation is involved, some small corrections for each slice are necessary or for each slice an individual dictionary has to be employed. For the other time-multiplexed versions shown in Figs. 2c and 2d, new and dedicated MRF trains would have to be designed, that are optimal for each individual slice / volume that is quasi simultaneously sampled. Once such region-specific trains are defined, the corresponding dictionaries for the different regions can be calculated in advance, considering the region-specific timings and scan conditions, making matching after the sampling process possible.

In the variant shown in Fig. 3, MRF trains for quasi simultaneous multi-slice / volume-sampling using multi-band RF pulses are applied. Multi-band excitation of MR signals is performed to excite a subset of two corresponding slices / volumes simultaneously in each gradient-echo sequence block. The multi-band factor, i.e the number of simultaneously excited slices / volumes, is smaller than the total number of slices / volumes sampled throughout the imaging sequence. Slices excited simultaneously by a multi-band RF pulse are linked by a small vertical line in the diagram. During the course of the imaging sequence, either slices / volumes (1+2), (1+3) or (2+3) are excited simultaneously using the same sequence block-specific flip angle, indicated by the identical grey levels of the respective pairs. Such blocks are repeated (after potential spin inversion in the beginning of each block or other magnetization preparation, not shown) with varying acquisition parameters (flip angle, TE, TR, ...). Hence, as in Fig. 2, the MRF train samples the slices / volumes quasi-simultaneously in a time-multiplexed manner under variation of the acquisition parameters.

Fig. 4 illustrates an MRF train for quasi simultaneous multi-slice / volume-sampling using a mixture of single-band and multi-band RF pulses. In this scheme, single-band or multi-band excitation is used in each basic gradient-echo sequence block. Periods in which only single-band RF pulses are applied are indicated with asterisks over the diagram. A multi-band factor of 2 is assumed in the example to excite two corresponding slices / volumes simultaneously, shown here by the same grey levels of the respective pairs.

The MRF train shown in Fig. 5 uses single-band RF pulses and magnetization preparation for quasi simultaneous multi-slice / volume-sampling. In this scheme, three slices or volumes are addressed by the MRF scan quasi-simultaneously in a time-multiplexed fashion, wherein MR signal generation and/or manipulation takes place in only one slice / volume at a given point in time. Additionally, magnetization preparation steps (indicated by small squares preceding some of the sequence blocks) are inserted which can be used to tailor the temporal MR signal evolution. Possible types of magnetization preparation are magnetization inversion, (partial) saturation, T₂-preparations, etc., which can be applied in a slice / volume-specific manner, or others like off-resonant magnetization transfer, spin-locking, chemical shift-selective partial inversion recovery, fat suppression, etc., which can only be applied to all slices / volumes simultaneously.

In all shown embodiments, each sequence block does not necessarily contain only a single RF pulse and MR signal readout, but multiple RF pulses and readouts. The latter implementation has the advantage that both short-timescale MR signal evolution (within a sequence block) and long-timescale MR signal evolution (between different sequence blocks) can be observed. Since this increases the wait time for inactive slices / volumes in the respective multiplexing schemes, the number of RF excitations per sequence block is typically limited by the relaxation times of the spin system. It may also be required to restrict the number of slices / volumes to be sampled quasi-simultaneously.

## Claims

1. Method of MR imaging of an object (10) placed in an examination volume of an MR system (1), the method comprising the steps of:
- subjecting the object (10) to an imaging sequence which generates MR signals in two or more spatially separate slices or volumes, wherein the imaging sequence is composed of a train of sequence blocks, each sequence block comprising at least one RF pulse and at least one switched readout magnetic field gradient defining a k-space sampling pattern and having associated therewith a set of acquisition parameters,
- acquiring the MR signals, wherein the MR signals are generated and/or manipulated in only a subset of said slices or volumes during each sequence block to acquire the MR signals in a time-multiplexed manner from all of the slices or volumes while simultaneously varying at least one acquisition parameter during the course of the imaging sequence, and
- reconstructing at least one MR image for each slice or volume, wherein one or more MR parameters are computed for a number of image positions from the temporal evolution of the acquired MR signals caused by the variation of the at least one acquisition parameter.

2. Method of claim 1, wherein the RF pulses of at least some of the sequence blocks are single-band RF pulses to generate MR signals in only a single slice or volume.

3. Method of claim 2, wherein the MR signals are generated in only a single slice or volume during each sequence block.

4. Method of claim 1 or 2, wherein the RF pulses of at least some of the sequence blocks are multi-band RF pulses generating MR signals in each slice or volume of the subset.

5. Method of claim 4, wherein the MR signals are generated and/or manipulated in two or more slices or volumes simultaneously during each sequence block.

6. Method of claim 4 or 5, wherein the multi-band RF pulses are designed to impart a modulation onto the MR signals generated in the slices or volumes of the subset.

7. Method of any one of claim 1-6, wherein the acquisition parameters varied during the course of the imaging sequence are one or more of: repetition time, echo time, flip angle, RF pulse phase and/or frequency, k-space sampling pattern, readout magnetic field gradient, longitudinal magnetization preparation.

8. Method of any one of claims 1-7, wherein said one or more MR parameters computed from the temporal evolution of the acquired MR signals are one or more of: T₁, T₂, spin density, diffusion coefficient, main magnetic field B₀.

9. Method of any one of claim 1-8, wherein said one or more MR parameters are computed by matching the temporal evolution of the acquired MR signals at a given image position against a set of predicted MR signal evolution patterns.

10. MR system comprising at least one main magnet coil (2) for generating a main magnetic field within an examination volume, a number of gradient coils (4, 5, 6) for generating switched magnetic field gradients in different spatial directions within the examination volume, at least one RF coil (9) for generating RF pulses within the examination volume and/or for receiving MR signals from an object (10) positioned in the examination volume, a control computer (15) for controlling a temporal succession of RF pulses and switched magnetic field gradients based on an examination protocol (32), and a reconstruction unit (17) for reconstructing MR images (33) from the received MR signals, wherein the MR system (1) is arranged to perform the following steps:
- subjecting the object (10) to an imaging sequence which generates MR signals in two or more spatially separate slices or volumes, wherein the imaging sequence is composed of a train of sequence blocks, each sequence block comprising at least one RF pulse and at least one switched readout magnetic field gradient defining a k-space sampling pattern and having associated therewith a set of acquisition parameters,
- acquiring the MR signals, wherein the MR signals are generated and/or manipulated in only a subset of the slices or volumes during each sequence block to acquire the MR signals in a time-multiplexed manner from all of the slices or volumes while simultaneously varying at least one acquisition parameter during the course of the imaging sequence, and
- reconstructing at least one MR image for each slice or volume, wherein one or more MR parameters are computed for a number of image positions from the temporal evolution of the acquired MR signals caused by the variation of the at least one acquisition parameter.

11. Computer program, which computer program comprises instructions for:
- executing an imaging sequence which generates MR signals in two or more spatially separate slices or volumes, wherein the imaging sequence is composed of a train of sequence blocks, each sequence block comprising at least one RF pulse and at least one switched readout magnetic field gradient defining a k-space sampling pattern and having associated therewith a set of acquisition parameters, and
- acquiring the MR signals, wherein the MR signals are generated and/or manipulated in only a subset of the slices or volumes during each sequence block to acquire the MR signals in a time-multiplexed manner from all of the slices or volumes while simultaneously varying at least one acquisition parameter during the course of the imaging sequence.

12. Computer program of claim 13, further comprising instructions for reconstructing at least one MR image for each slice or volume, wherein one or more MR parameters are computed for a number of image positions from the temporal evolution of the acquired MR signals caused by the variation of the at least one acquisition parameter.
